# EUROPEAN PATENT APPLICATION

(11) **EP 4 310 221 A1**
(43) Date of publication of application: **24.01.2024**
(21) Application number: 22186217.0
(22) Date of filing: 21.07.2022
(51) Int. Cl.: C23C 18/16, C23C 18/40, C23C 18/54, C23C 18/18, H01L 21/768, H01L 21/288, H05K 3/18, C23C 18/20

(54) **ELECTROLESS COPPER PLATING BY MEANS OF A CATALYTIC REACTION**

(71) Applicant: Infineon Technologies AG, 85579 Neubiberg (DE)
(72) Inventor: WAN, Tatt Wai, 11700 Gelugor Penang (MY); CHEW, Cui Min, 08000 Sungai Petani, Kedah Darul Aman (MY); LEE, Chee Hong, 76450 Melaka (MY); LEE, Swee Kah, 75350 Batu Berendam (MY); TAN, Chan Lik, 09090 Kulim, Kedah (MY); TEH, Khye Lynn, 34000 Taiping, Perak (MY)
(74) Representative: Lambsdorff & Lange Patentanwälte Partnerschaft mbB

(57) **Abstract**

A metal layer stack (10) comprises a barrier layer (1) capable of acting as a displacement layer for palladium deposition, a first palladium seeding cluster layer (2) disposed on the barrier layer, a first copper layer (3) disposed on the first palladium seeding cluster (2), a second palladium seeding cluster layer (4) disposed on the first copper layer (3), and a second copper layer (5) disposed on the second palladium seeding cluster layer (4).

## Description

### TECHNICAL FIELD

The present disclosure is related to a metal layer stack and a method for fabricating a metal layer stack.

### BACKGROUND

Electroless copper plating is a chemical process for the deposition of an even layer of copper on the surface of a solid substrate, like metal or plastic. The process involves dipping the substrate in a water solution containing copper salts and a reducing agent such as formaldehyde. Unlike electroplating, electroless plating process in general does not require passing of an electric current through the bath and the substrate; the reduction of the metal cations in solution to metallic is achieved by purely chemical means, through an autocatalytic reaction. Thus electroless plating creates an even layer of metal regardless of the geometry of the surface - in contrast to electroplating which suffers from uneven current density due to the effect of substrate shape on the electric field at its surface. Electroless plating can be applied to non-conductive surfaces such as silicon substrate.

However, in certain applications, electrodeless plating faces difficulties, especially when it comes to deposition on certain materials. As an example, the adhesion of Cu on Tungsten (W) is weak if electroless Cu plating is applied directly on the surface. Tungsten is very well known to function as a barrier layer in the field of fabricating metal stacks. Another problem with today's electroless copper deposition is the use of formaldehyde as a stabilizer, since formaldehyde is hazardous and fuming and there is in general an increasing trend to ban it.

For these and other reasons there is a need for the present disclosure.

### SUMMARY

A first aspect of the present disclosure is related to a metal layer stack comprising a barrier layer capable of acting as a displacement layer for palladium deposition, a first palladium seeding cluster layer disposed on the barrier layer, a first copper layer disposed on the first palladium seeding cluster layer, a second palladium seeding cluster layer disposed on the first copper layer, and a second copper layer disposed on the second palladium seeding cluster layer.

A second aspect of the present disclosure is related to a method for fabricating a metal layer stack, the method comprising depositing copper layers by electroless deposition, and the method further comprising providing a barrier layer capable of acting as a seed layer for copper plating, depositing a first palladium seeding cluster layer onto the base layer, depositing a first copper layer onto the first palladium seeding cluster layer, depositing a second palladium seeding cluster layer onto the first copper layer, and depositing a second copper layer onto the second palladium seeding cluster layer.

A third aspect of the present disclosure is related to an electronic device comprising a metal layer stack according to the first aspect.

A forth aspect of the present disclosure is related to a method for fabricating an electrical structure, the method comprising depositing at least one copper layer by electroless deposition, wherein depositing the at least one copper layer comprises using a copper plating solution comprising a copper containing compound and an inorganic stabilizer.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a cross-sectional side view of a metal layer stack according to the first aspect.
Fig. 2 shows a flow diagram of an exemplary method for fabricating a metal layer stack according to the second aspect.
Fig. 3 comprises Fig. 3(1) to 3(5) and shows schematic cross-sectional side view representations for illustrating an example of an exemplary method for fabricating a metal layer stack according to the second aspect.
Fig. 4 shows a flow diagram of an exemplary method for fabricating a metal layer stack according to the second aspect.
Fig. 5 illustrates a possible mechanism for electroless plating of copper.
Fig. 6 comprises Fig. 6A and 6B and shows cross-sectional side view representations of electrical structures, a first one comprising an electrical copper via (A) and a second one comprising a copper layer on a plateable encapsulant layer, both electrical structures fabricated by electroless deposition of the copper layer.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

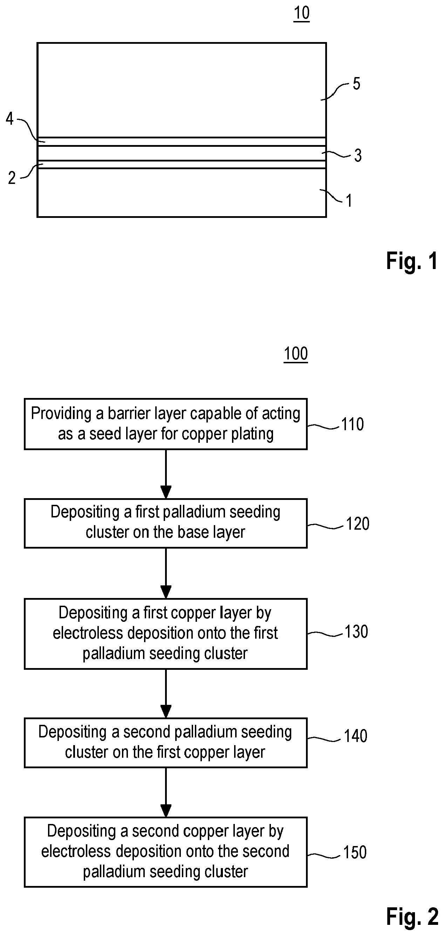

Fig. 1 shows a cross-sectional side view of a metal layer stack according to the first aspect.

More specifically, Fig. 1 shows a metal layer stack 10 comprising a barrier layer 1, a first palladium seeding cluster layer 2 disposed on the barrier layer 1, a first copper layer 3 disposed on the first palladium seeding cluster 2, a second palladium seeding cluster layer 4 disposed on the first copper layer 3, and a second copper layer 5 disposed on the second palladium seeding cluster layer 4.

In most cases the metal layer stack is provided to electrically connect a contact pad of a semiconductor die, in particular a silicon die, arranged underneath. The barrier layer 1 serves to protect the semiconductor die from the penetration of foreign substances such as copper. In the present case, the material of the barrier layer is further such that it is able to serve as a displacement layer for the subsequent deposition of palladium. These properties can be fulfilled by choosing tungsten or titanium as the material for the barrier layer 1 although also other materials are also conceivable.

For simplicity, the first palladium seeding cluster layer is shown here as a continuous layer, but this is not necessarily the case. In fact, the first palladium seeding cluster layer may be a discontinuous layer with for example, a disjointed distribution of palladium clusters, as will be shown later in more detail. The first palladium seeding cluster layer 2 can therefore have a thickness of, for example, only one or two atomic layers. The first palladium seeding cluster layer 2 will serve to facilitate deposition of the first copper layer 3 by a catalytic reaction.

During growth of the metal layer stack 10, the first copper layer 3 may function as a seed layer. A thickness of the first copper layer 3 may be in a range from 10 nm to 200 nm, more specifically in a range from 50 nm to 100 nm. The deposition of a thin first copper layer 3 which functions as a seed layer advantageously helps to provide a more uniform and better adhesive surface for the deposition of a subsequent thicker second copper layer 5 forming the copper bulk.

Fig. 2 shows a flow diagram of an exemplary method for fabricating a metal layer stack according to the second aspect.

More specifically, the method 100 of Fig. 2 comprises providing a barrier layer capable of acting as a seed layer for copper plating (110), depositing a first palladium seeding cluster layer onto the base layer (120), depositing a first copper layer by electroless deposition onto the first palladium seeding cluster (130), depositing a second palladium seeding cluster layer onto the first copper layer (140), and depositing a second copper layer by electroless deposition onto the second palladium seeding cluster layer (150).

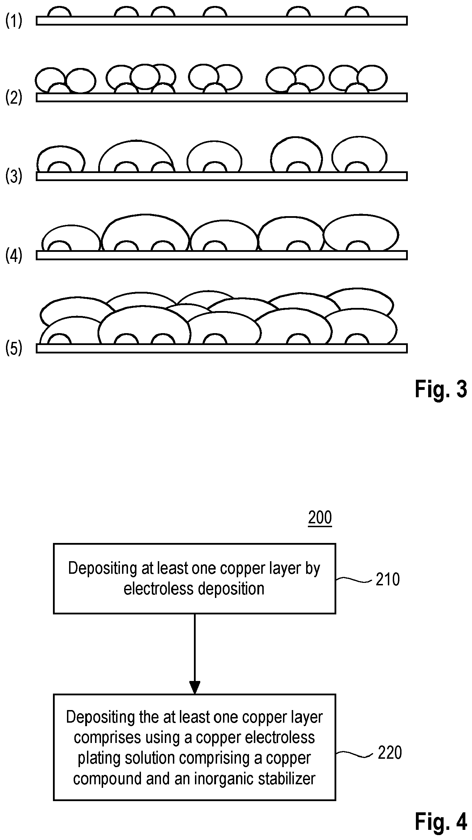

Fig. 3 comprises Fig. 3(1) to 3(5) and shows schematic cross-sectional side view representations for illustrating an example of the first stages of an exemplary method for fabricating a metal layer stack according to the second aspect.

Providing a barrier layer as part of a batch process typically involves providing a wafer containing a plurality of pre-processed semiconductor devices with contact pads on major surfaces of the semiconductor devices. Then a respective plurality of barrier layers are fabricated on the contact pads of the semiconductor dies, which barrier layers serve to protect the semiconductor dies from the penetration of foreign substances such as copper in particular a silicon die, arranged underneath. The barrier layers can be comprised e.g. of tungsten layers.

Before depositing the first palladium seeding cluster layer, the wafer may be processed by dipping it into a cleaning solution. The cleaning solution removes contaminants and may have a slight etching effect on the underlying barrier layer. For example, a cleaning solution containing 5% KOH and H₂SO₄ may be used. Other cleaning solutions with similar functions may also be suitable.

In some embodiments, depositing the first palladium seeding cluster may comprise dipping the wafer into a diluted solution of PdSO₄ for e.g. 5-10 minutes. Dipping the wafer into the PdSO₄ solution (e.g. 13 ppm) will only deposit a discontinuous first palladium seeding cluster layer comprising thin and scarcely distributed palladium clusters or islands. The result can be seen in Fig. 3(1), namely a disjointed distribution of palladium clusters 2 adsorbed on the upper main surface of the tungsten barrier layer 1. The palladium clusters 2 will act as catalysts for the subsequent deposition of the first copper layer.

The first copper layer is then deposited onto the first palladium seeding cluster layer by electroless copper deposition. This may comprise dipping the wafer dipped into a copper plating bath for e.g. 1 minute. The copper plating bath may be a conventional copper electroless plating bath or a plating bath using an inorganic stabilizer and a reducing agent comprising one or both of glyoxylic acid and hypophosphite.

The deposition of the first palladium seeding cluster layer 2 on a barrier layer 1 (e.g. tungsten or titanium) has the effect of causing the deposition of first copper 3 to occur by way of catalytic reaction instead of displacement reaction. In a displacement reaction, copper is deposited on the surface of the barrier layer 1 by displacing barrier layer material (e.g. tungsten). On the other hand, catalytic reactions are generally chemical reactions activated by the catalyst on the reactants, forming chemical intermediates that are able to react more readily with each other or with another reactant, to form the desired end product. In some embodiments, the catalytic effect of the palladium is achieved by depositing palladium in the form of islands or clusters on the surface of the barrier layer 1. Preferably, the first palladium seeding cluster layer may comprise a discontinuous layer with disjointed distribution of palladium islands as shown in Fig. 3(1). During the subsequent first copper layer deposition, copper is deposited preferentially on the palladium clusters by forming intermediate Pd/Cu compounds at the boundaries. In this way copper agglomerates are formed on the Pd clusters.

The result can be seen in Fig. 3(2), namely a plurality of copper particles agglomerated around the palladium clusters. These copper particles then grow together in the further course of the reaction to form copper clusters or islands, as can be seen in Fig. 3(3). In the further course of the reaction, these copper clusters increase in size and form a continuous film (see Fig. 3(4)) which further builds up in thickness (see Fig. 3(5)) to form the first copper layer 3.

In some embodiments, the first copper layer 3 functions as a copper seed layer. The first copper layer may, for example, have a thickness in a range from 10 nm to 200 nm, more specifically in a range from 50 nm to 100 nm. The deposition of a thin first copper layer 3 which functions as a seed layer advantageously helps to provide a more uniform and better adhesive surface for the deposition of a subsequent thicker second copper layer 5 forming the copper bulk.

Thereafter the wafer can be dried and an annealing step may be carried out in order to relief any stress build up in the first copper layer 3 and to provide for better adhesion between the first copper layer 3 and the subsequently deposited second palladium cluster layer 4. The annealing step may be carried out e.g. at 100°C - 160°C for e.g. 5 mins to few hrs in N2 ambient. In some embodiments, any copper oxide deposited on the wafer during the annealing process may be removed by dipping into an acidic solution such as H₂SO₄ for e.g. 1 minute and thereafter rinsed in deionized water.

A second palladium seeding cluster layer 4 is subsequently deposited onto the first copper layer 3. This may be performed by dipping the wafer into a palladium containing solution such as a diluted solution of PdSO₄ for e.g. 2-5 minutes. Other palladium containing solutions such as PdSO4, PdCl2, PdNo3 may also be used instead. In some embodiments, dipping the wafer into the PdSO₄ solution will again only deposit some thin and scarcely distributed palladium clusters or islands. In other embodiments, the second palladium cluster layer may also be a continuous layer. The inventors have discovered that the second palladium seeding cluster layer 4 provides a bimetallic catalysis effect which has better catalytic performance compared to instances where there is only a single metallic catalyst in the form of a single palladium layer.

Thereafter the wafer can be rinsed in deionized water.

In some embodiments, the second copper layer 5 may be deposited onto the second palladium seeding cluster layer 4 by dipping the wafer into a copper plating bath for e.g. 30 minutes. The copper plating bath may be concentrated copper plating bath. The copper plating bath may also be a conventional concentrated copper electroless plating bath or a plating bath comprising an inorganic stabilizer and a reducing agent comprising one or both of glyoxylic acid and hypophosphite. Preferably, the second copper layer 5 is deposited at a higher plating rate as compared to the plating rate associated with the deposition of the first copper layer 3.

When depositing the second copper layer 5, the second palladium seeding cluster layer 4 has an even stronger catalytic effect than when depositing the first copper layer 3 on the first palladium cluster layer 2. In the present case the catalyst in the form of the palladium clusters and the reactant in the form of the deposited copper may form intermediate products in the form of Pd/Cu alloys. The presence of these Pd/Cu alloys lowers the activation energy of the chemical reaction and thus makes the chemical reaction faster and easier. It has already been shown that Pd-Cu alloy catalyst is more efficient than single Pd catalyst. The deposition of the second copper layer 5 is thus based on two effects, namely firstly the effect of the first copper layer 3 as a seed layer and secondly the catalytic effect of the palladium-copper alloys formed.

The wafer can then be rinsed with deionised water and then dried by blowing on.

Fig. 4 shows a flow diagram of an exemplary method for fabricating a metal layer stack according to the second aspect.

More specifically, the method 200 of Fig. 4 comprises depositing at least one copper layer by electroless deposition (210), wherein depositing the at least one copper layer comprises using a copper electroless plating solution comprising a copper containing compound and an inorganic stabilizer (220). The copper containing compound can include compounds that dissociate to produce Copper (II) ions. Examples include copper sulphate, copper chloride and combinations thereof.

According to an embodiment of the method 200 of Fig. 4, the inorganic stabilizer in the copper electroless plating solution comprises a refractory metal. In a preferred embodiment, the refractory metal comprises Molybdenate. Other refractory components such as tungstate may also be suitable.

In some embodiments, the copper plating solution used in the method 200 of Fig. 4 further comprises a reducing agent comprising one or both of glyoxylic acid and hypophosphite. Glyoxylic acid produces pure Cu while hypophosphite produces CuP.

According to an embodiment of the method 200 of Fig. 4, the reducing agent is free of formaldehyde. Reducing agents comprising glyoxylic acid and/or hypophosphite may be used in place of formaldehyde containing reducing agents.

According to an embodiment of the method 200 of Fig. 4, the copper electroless plating solution has a pH value from about 10 - 13. The desired pH value may be achieved by including in the copper electroless plating solution, an alkaline solution or hydroxide ion source such as potassium hydroxide (KOH), sodium hydroxide (NaOH).

The stabilization of the electroless plating is a crucial part of the whole process: due to the spontaneous nature of the plating reaction, it is necessary that reaction is favoured on the substrate - which is made possible by the intrinsic or synthetic catalytic activity of the substrate and deposited material and impeded everywhere else, which includes all other immersed surfaces and the bulk of the solution, which is the primary role of the stabilizing agent. The stabilisation of the electrodeless deposition is basically a de facto slowing down of the deposition process in order to bring about a targeted deposition only on the substrate.

The following Table I shows an example of a formulation for electroless plating of copper.

**Table I**

| Chemical | Volume | | Concentration |
|---|---|---|---|
| 80 g/L Cu.SO₄.5H₂O | 10 ml | | 0.03 M of Cu |
| 0.1 M EDTA | 50 ml | | 0.05 M of EDTA |
| 0.5 M Glyoxylic Acid | 10 ml | | 0.05 M of GA |
| Mo solution (inorganic stabilizer) | | | 0.1 mM to 3.0 mM |
| Deionized water | Top up to 100 ml | | |
| | | | |
| KOH/NaOH as pH adjuster | adjuster | pH 10 - 13 | |

As can be seen from the table I, the copper to be deposited is added to the solution in the form of copper sulphate pentahydrate which appears as blue crystalline granules or powder. EDTA stands for ethylenediaminetetraacetic acid or ethylenediaminetetraacetate and is known as a complexing agent. EDTA forms particularly stable complexes with Cu²⁺ ions, for which purpose it can be optionally and primarily used here. Glyoxylic acid is used here as a reducing agent and molybdenate as an inorganic stabilizer. To achieve the desired pH-value of 10 - 13, the required amount of KOH/NaOH is added.

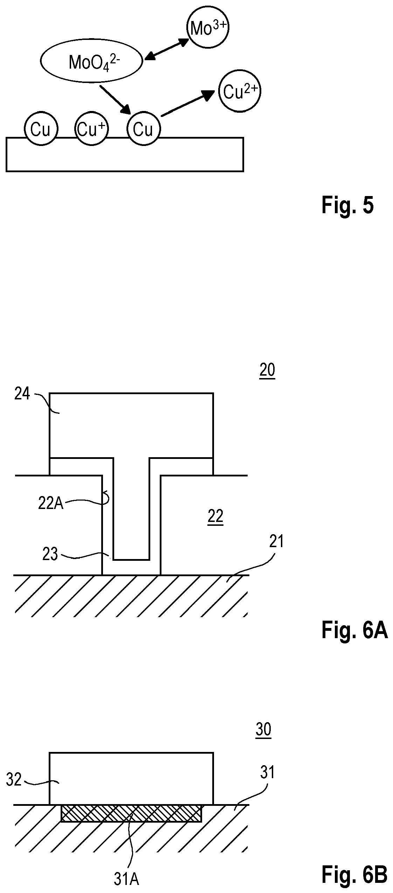

Fig. 5 illustrates a possible mechanism by which Molybdenate functions as a stabilizer in an electroless copper plating solution. This is not intended to be limiting on the disclosure and other refractory metals may also suitable as inorganic stabilizers. Cu(I) has a tendency to oxidize and form Cu(I) oxide. MoO₄²⁻ can oxidize Cu or Cu(I) to Cu(II), a more stable form of copper ion with a lower tendency to oxidize. This may happen through self-reduction of MoO₄²⁻ to Mo³⁺. At a relatively high pH such as pH 11, Mo³⁺ can be reoxidized back to MoO₄²⁻. Due to the temporary oxidation of Cu or Cu(I) to Cu(II), the plating rate of Cu is reduced and the process of depositing Cu is slowed down when Molybdenate is added as an inorganic stabilizer compared to when there is no stabilizer present in the electroless copper plating bath.

The disclosure according to the forth aspect in particular enables low cost application of electroless copper plating technology in any front end or back end application on products that required the relevant process. Two exemplary electrical structures will be shown in the following.

Fig. 6 comprises Fig. 6A and 6B and shows cross-sectional side view representations of electrical structures, a first one comprising an electrical copper via (A) and a second one comprising a copper layer on a plateable mold compound (B), both electrical structures fabricated by electroless deposition of a copper layer, respectively, according to the forth aspect.

More specifically, Fig. 6A shows an electrical structure 20 comprising a semiconductor substrate 21, in particular a contact area of a semiconductor die, an oxide layer 22 disposed on an upper surface of the substrate 21, the oxide layer 22 comprising an opening 22A. In the opening 22A a barrier layer 23 of e.g. tungsten or titanium is disposed covering the inner walls of the opening 22A. A copper layer 24 is then deposited into the opening 22A, the copper layer 24 covering the inner walls of the barrier layer 23. Such an electrical structure is in particular useful for applications in which a plurality of such electrical via connections have to be fabricated in parallel like e.g. in a final metallization layer.

And more specifically, Fig. 6B shows an electrical structure 30 comprising a plateable encapsulant layer 31, laser activated area 31A thereof, and a copper layer 32 deposited onto the laser activated area 31A.

The plateable encapsulation layer 31 may comprise a laser-activatable material as, for example, an additive like a laser direct structuring (LDS) additive, embedded in an encapsulant host material. Sweeping a laser beam over selected regions of the plateable encapsulant layer results in activating the laser-activatable material and turning the activated regions into electrically conductive regions. According to an example thereof, the additive is selected from the group consisting of any kinds of metal insulated with powder (in nano size), copper chromium oxide (spinel), copper hydroxide phosphate, copper phosphate, copper chromium oxide spinel, a copper sulfate, a cuprous thiocyanate, an organic metal complex, a palladium/palladium-containing heavy metal complex, a metal oxide, a metal oxide-coated filler, antimony doped tin oxide coated on mica, a copper containing metal oxide, a zinc containing metal oxide, a tin containing metal oxide, a magnesium containing metal oxide, an aluminum containing metal oxide, a gold containing metal oxide, a silver containing metal oxide, and a combination thereof.

In the present embodiment a type of LDS would be preferred which already contains copper as this type would form an ideal copper seed which would facilitate the subsequent electroless deposition of the copper layer 32.

It should be mentioned that each and every feature mentioned above in connection with one of the first to third aspects can be applied to the forth aspect and vice versa.

### EXAMPLES

In the following specific examples of the present disclosure are described.

Example 1 is a metal layer stack comprising a barrier layer capable of acting as a displacement layer for palladium deposition, a first palladium seeding cluster layer disposed on the barrier layer, a first copper layer disposed on the first palladium seeding cluster layer, a second palladium seeding cluster layer disposed on the first copper layer, and a second copper layer disposed on the second palladium seeding cluster layer.

Example 2 is the metal layer stack according to Example 1, wherein the first palladium seeding cluster layer facilitates deposition of the first copper layer by a catalytic reaction.

Example 3 is the metal layer stack according to Example 1 or 2, wherein one or both of the first palladium seeding cluster layer and the second palladium seeding cluster layer is a discontinuous layer.

Example 4 is the metal layer stack according to any one of the preceding Examples, wherein one or both of the first palladium seeding cluster layer and the second palladium seeding cluster layer are being formed based on a displacement reaction.

Example 5 is the metal layer stack according to Example 4, wherein one or both of the first palladium seeding cluster layer and the second palladium seeding cluster layer are either continuous or discontinuous.

Example 6 is the metal layer stack according to any one of the preceding Examples, wherein the first copper layer functions as a copper seed layer.

Example 7 is the metal layer stack according to any one of the preceding Examples, wherein the barrier layer comprises one of tungsten or titanium.

Example 8 is the metal layer stack according to any one of the preceding Examples, wherein a thickness of the first copper layer is in a range from 10 nm to 200 nm.

Example 9 is an electronic device comprising a metal layer stack according to any one of the preceding Examples.

Example 10 is a method for fabricating an electrical structure, the method comprising depositing at least one copper layer by electroless deposition, and the method **characterized by**
providing a barrier layer capable of acting as a displacement layer for copper plating;
depositing a first palladium seeding cluster layer onto the base layer;
depositing a first copper layer onto the first palladium seeding cluster layer;
depositing a second palladium seeding cluster layer onto the first copper layer; and
depositing a second copper layer onto the second palladium seeding cluster layer.

Example 11 is the method according to Example 10, further comprising performing an annealing step after depositing the first copper layer.

Example 12 is the method according to Example 10or 11, wherein one or both of the first palladium cluster layer and the second palladium cluster layer is a discontinuous layer.

Example 13 is the method according to any one of Examples 10 to 12, wherein depositing the first and second palladium seeding cluster layers comprises dipping into a palladium containing solution.

Example 14 is the method according to any one of Examples 10 to 13, wherein depositing the first and second copper layers comprises dipping into a concentrated copper electroless plating bath.

Example 15 is the method according to any one of Examples 10 to 14, wherein one or both of the first palladium cluster layer and the second palladium cluster layer is a discontinuous layer.

Example 16 is the method according to any one of Examples 10 to 15, wherein the first palladium seeding cluster layer facilitates deposition of the first copper layer by a catalytic reaction.

Example 17 is the method according to any one of Examples 10 to 16, wherein the first copper layer functions as a copper seed layer.

Example 18 is method according to any one of Examples 10 to 17, wherein the barrier layer comprises one of tungsten or titanium.

Example 19 is the method according to any one of Examples 10 to 18, comprising depositing the first copper layer so that a thickness of the first copper layer is in a range from 10 nm to 200 nm.

Example 20 is the method according to any one of Examples 10 to 21 or to the preamble of Example 10, wherein depositing the at least one copper layer comprises using a copper electroless plating solution comprising a copper ion source and an inorganic stabilizer.

Example 21 is the method according to Example 20, wherein the inorganic stabilizer comprises a refractory metal.

Example 22 is the method according to Example 21, wherein the refractory metal comprises Molybdenate and/or tungstate.

Example 23 is the method according to any one of Examples 10 to 22, wherein the copper electroless plating solution further comprises a reducing agent comprising one or both of glyoxylic acid and hypophosphite.

Example 24 is the method according to Example 23, wherein the reducing agent is free of formaldehyde.

Example 25 is the method according to any one of Examples 10 to 24 and to the preamble of Example 10, wherein depositing the at least one copper layer onto a laser activated region of a plateable encapsulant layer.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A metal layer stack (10), comprising
a barrier layer (1) capable of acting as a displacement layer for palladium deposition;
a first palladium seeding cluster layer (2) disposed on the barrier layer;
a first copper layer (3) disposed on the first palladium seeding cluster layer (2);
a second palladium seeding cluster layer (4) disposed on the first copper layer (3); and
a second copper layer (5) disposed on the second palladium seeding cluster layer (4).

2. The metal layer stack (10) according to claim 1, wherein the first palladium seeding cluster layer (2) facilitates deposition of the first copper layer (3) by a catalytic reaction.

3. The metal layer stack (10) according to claim 1 or 2, wherein
one or both of the first palladium cluster layer (2) and the second palladium cluster layer (4) is a discontinuous layer.

4. The metal layer stack (10) according to any one of the preceding claims, wherein
one or more of the first palladium seeding cluster layer (2) and the second palladium seeding cluster layer (4) are being formed based on a displacement reaction.

5. The metal layer stack (10) according to any one of the preceding claims, wherein
the first copper layer (3) functions as a copper seed layer.

6. The metal layer stack (10) according to any one of the preceding claims, wherein
the barrier layer (1) comprises one of tungsten or titanium.

7. The metal layer stack (10) according to any one of the preceding claims, wherein
a thickness of the first copper layer (3) is in a range from 10 nm to 200 nm.

8. An electronic device, comprising
a metal layer stack according to any one of the preceding claims.

9. A method (100) for fabricating an electrical structure, the method comprising
depositing at least one copper layer by electroless deposition, and the method
**characterized by**
providing a barrier layer capable of acting as a displacement layer for palladium deposition (110);
depositing a first palladium seeding cluster layer onto the barrier layer (120);
depositing a first copper layer onto the first palladium seeding cluster layer (130);
depositing a second palladium seeding cluster layer onto the first copper layer (140); and
depositing a second copper layer onto the second palladium seeding cluster layer (150).

10. The method (100) according to claim 9, further comprising performing an annealing step after depositing the second copper layer.

11. The method (100) according to claim 9 or 10, wherein
one or both of the first palladium cluster layer (2) and the second palladium cluster layer (4) is a discontinuous layer.

12. The method (100) according to any one of claims 9 to 11, wherein
depositing the first and second palladium seeding cluster layers (2, 4) comprises dipping into a palladium containing solution.

13. The method (100) according to any one of claims 9 to 12, wherein
depositing the first and second copper layers comprises dipping into a concentrated copper electroless plating bath.

14. The method (100) according to any one of claims 9 to 13, wherein
the first palladium seeding cluster layer facilitates deposition of the first copper layer by a catalytic reaction.

15. The method (100) according to any one of claims 9 to 14, wherein
the first copper layer functions as a copper seed layer.

16. The method (100) according to any one of claims 8 to 12, wherein
the barrier layer comprises one of tungsten or titanium.

17. The method (100; 200) according to any one of claims 9 to 16 or to the preamble of claim 9, wherein
depositing the at least one copper layer comprises using a copper electroless plating solution comprising a copper ion source and an inorganic stabilizer.

18. The method (100; 200) according to claim 17, wherein the inorganic stabilizer comprises a refractory metal.

19. The method (100; 200) according to claim 18, wherein the refractory metal comprises Molybdenate and/or tungstate.

20. The method (100; 200) according to any one of claims 17 to 19, wherein
the copper electroless plating solution has a pH from about 10 to 13.

21. The method (100; 200) according to any one of claims 17 to 20, wherein
the copper electroless plating solution further comprises a reducing agent comprising one or both of glyoxylic acid and hypophosphite

22. The method (100; 200) according to claim 21, wherein the reducing agent is free of formaldehyde.

23. The method (100, 200) according to any one of claims 17 to 22 and to the preamble of claim 9, wherein
depositing the at least one copper layer onto a laser activated region of a plateable encapsulant layer.
